(19) Europäisches Patentamt
European Patent Office
Office européen des brevets

(11) **EP 2 106 461 B1**

(12) **EUROPÄISCHE PATENTSCHRIFT**

(45) Veröffentlichungstag und Bekanntmachung des Hinweises auf die Patenterteilung:
**04.04.2012   Patentblatt 2012/14**

(21) Anmeldenummer: **07857182.5**

(22) Anmeldetag: **12.12.2007**

(51) Int Cl.:
*C23C 16/04* (2006.01)     *C23C 16/511* (2006.01)
*C03C 17/30* (2006.01)     *B05D 7/24* (2006.01)
*B05D 7/22* (2006.01)     *C03C 17/00* (2006.01)
*C03C 17/245* (2006.01)     *C23C 16/02* (2006.01)
*B05D 5/08* (2006.01)     *C23C 16/40* (2006.01)
*C23C 16/515* (2006.01)

(86) Internationale Anmeldenummer:
**PCT/EP2007/011493**

(87) Internationale Veröffentlichungsnummer:
**WO 2008/071458 (19.06.2008 Gazette 2008/25)**

(54) **BEHÄLTER MIT VERBESSERTER RESTENLEERBARKEIT UND VERFAHREN ZU DESSEN HERSTELLUNG**

CONTAINER HAVING IMPROVED EASE OF DISCHARGE PRODUCT RESIDUE, AND METHOD FOR THE PRODUCTION THEREOF

RÉCIPIENT À CAPACITÉ AMÉLIORÉE DE VIDAGE À FOND, ET SON PROCÉDÉ DE FABRICATION

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **12.12.2006   DE 102006058771**

(43) Veröffentlichungstag der Anmeldung:
**07.10.2009   Patentblatt 2009/41**

(73) Patentinhaber: **Schott AG**
**55122 Mainz (DE)**

(72) Erfinder:
• BICKER, Matthias
  55126 Mainz (DE)
• BAUCH, Hartmut
  61276 Weilrod (DE)
• HAHN, Andreas
  55606 Hochstetten-Dhaun (DE)
• BAUER, Stefan
  55232 Alzey (DE)
• LOHMEYER, Manfred
  55299 Nackenheim (DE)
• HORMES, Robert
  9116 Wolfertswil (CH)

(74) Vertreter: **Herden, Andreas F.**
**Blumbach - Zinngrebe**
**PatentConsult**
**Patentanwälte**
**Alexandrastrasse 5**
**65187 Wiesbaden (DE)**

(56) Entgegenhaltungen:
WO-A-03/031362     DE-A1- 10 258 681
DE-C1- 19 629 877     DE-C1- 19 921 303

• WALKIEWICZ-PIETRZYKOWSKA AGNIESZKA ET AL: "Type of precursor and synthesis of silicon oxycarbide (SiOxCyH) thin films with a surfatron microwave oxygen/argon plasma" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 24, Nr. 4, 22. Mai 2006 (2006-05-22), Seiten 988-994, XP012091163 ISSN: 0734-2101

**Beschreibung**

Die Erfindung betrifft allgemein die Herstellung von Beschichtungen mittels CVD-Abscheidung und im speziellen ein Verfahren zum Aufbringen von hydrophoben Schichten auf ein Substrat, sowie verfahrensgemäß herstellbaren Erzeugnissen.

Besonders auf dem Gebiet der Verpackungstechnik und auch auf dem Gebiet medizinischer Packmittel besteht ein ständig steigendes Interesse an Behältern, welche mit einer Barriereschicht beschichtet sind. Glasähnliche Barriereschichten, die Siliziumoxid enthalten, sind in diesem Zusammenhang besonders interessant, weil diese mehrere wünschenswerte Eigenschaften aufweisen. So sind diese zum Beispiel transparent, recyclebar und für den Gebrauch in Mikrowelleneinrichtungen geeignet. In dieser Hinsicht sind glasähnliche Barriereschichten dünnen Metallschichten, wie sie derzeit kommerziell auf verschiedenen Polymersubstraten aufgebracht werden, überlegen.

Speziell auf dem Gebiet medizinischer Packmittel, wie etwa von Vials ist es weiterhin wünschenswert, wenn die verpackten Stoffe möglichst vollständig entleert werden können. Hier trägt gerade bei flüssigen Pharmazeutika auch die Haftung des verpackten Stoffs an der Behälterwandung bei, wobei dieser Beitrag mit sinkender Packungsgröße im Verhältnis sogar ansteigt. Dieser Effekt ist unter anderem bereits deshalb unerwünscht, weil es dadurch zu Dosierungsschwankungen kommen kann. Außerdem kann bei teuren Medikamenten ein merkbarer Verlust entstehen.

Um diesen Problemen abzuhelfen, sind aus dem Stand der Technik hydrophobe Beschichtungen bekannt. Ein solcher Ansatz liegt im Aufbringen von Silikonölen oder dem Einbacken von Silikonöl-Emulsionen. Bekannt sind derartige Beschichtungen beispielsweise aus der US 2,504,482 A. Hier bestehen allerdings folgende Nachteile: Es sind dicke Schichten erforderlich, woraus erhöhte Risiken hinsichtlich der Auslaugung der Silikonöle und der Bildung von verunreinigenden Partikeln aus Silikon resultieren. Auch kann der Herstellungsprozess mit sehr viel Ausschuss verbunden sein. Der Herstellungsprozess ist schwer zu überwachen und die Qualitätssicherung ist problematisch.

Ein weiterer Ansatz liegt in der Beschichtung mit Fluorhaltigen Schichten, wie sie aus der DE 199 21 303 C1 bekannt sind. Dazu sind Beschichtungen vorgesehen, die neben Fluor auch die Elemente Si, C, O und H enthalten, wobei für den Fluor- und Kohlenstoffgehalt gilt, daß bei Fluorgehalten kleiner 0,1% der Kohlenstoffgehalt größer oder gleich 10% und bei Fluorgehalten größer oder gleich 0,1% der Kohlenstoffanteil größer oder gleich 5% beträgt.

Allerdings können hohe Siliziumgehalte, je nach Art des verpackten Materials inkompatibel oder unerwünscht sein. Gleiches kann auch für das enthaltene Fluor gelten. Zudem läßt der Kontaktwinkel der aus der DE 199 21 303 C1 bekannten Schichten nach dem Autoklavieren nach.

Aus der DE 102 58 681 A1 ist ein Verfahren zur Herstellung von glatten Barriereschichten mittels gepulstem PCVD-Verfahren bekannt. Die abgeschiedene organische Schicht fungiert jedoch als Haftvermittler zwischen der auf ihr abgeschiedenen anorganischen Schicht und dem Substrat. Dem zu Folge werden keine hydrophoben Eigenschaften der organischen Schicht offenbart.

Der Fachartikel "Type of precursor and synthesis of silicon oxycarbide ($SiO_xC_yH$) thin films with a surfatron microwave oxygen/argon plasma" zeigt die Synthese dünner, siliconähnlicher Filme durch kontinuierlichem PECVD, wobei auf die Abhängigkeit der Abscheiderate vom Sauerstoffvolumen eingegangen wird. Der maximale Kontaktwinkel von Wasser beträgt 92°.

Aus DE 199 21 303 C1 sind hydrophob beschichtete Glasbehälter zur Aufbewahrung pharmazeutischer Lösungen bekannt. Jedoch werden hier perfluorierte Precursor verwendet, so dass die hydrophoben Eigenschaften auch durch fluorophobe Wechselwirkungen verursacht werden.

In DE 195 43 133 A1 wird ein Verfahren zur Erzeugung hydrophober Polymerschichten mit der Zusammensetzung SiOxCyHz mittels Plasmapolymerisation beschrieben. Bei den Monomeren handelt es sich um Vinylsilane, die Polymerisation erfolgt durch Energieeintrag über Öffnung der Doppelbindungen bei gleichzeitigem Strukturerhalt. Der hydrophobe Effekt der so erzeugten Schicht beruht auf ihrer speziellen Oberflächenmorphologie.

Der Erfindung liegt daher die Aufgabe zugrunde, siliziumarme Beschichtungen bereitzustellen, die sehr hydrophob sind und eine weiter verbesserte Temperaturbeständigkeit aufweisen.

Diese Aufgabe wird bereits in höchst überraschend einfacher Weise durch den Gegenstand der unabhängige Ansprüche gelöst. Vorteilhafte Ausgestaltungen und Weiterbildungen der Erfindung sind in den abhängigen Ansprüchen angegeben.

Die Erfindung sieht ein medizinisches Packmittel vor, mit einem Substrat und einer obersten Schicht, wobei das Verbundmaterial geeignet für eine Verbesserung der Restentleerbarkeit von Packmitteln, und wobei durch die Schichtoberfläche das Benetzungs- oder Ablaufverhalten von Flüssigkeiten oder Suspensionen gegenüber dem unbeschichteten Substratmaterials veränderbar ist.

Das medizinische Packmittel weist dazu ein Substrat und eine darauf abgeschiedene Beschichtung auf, die zumindest einen Teil der Oberfläche des beschichteten Substrats formt. Die Beschichtung weist als maßgeblichen Bestandteil eine Verbindung mit den Elementen Si, C, O und H auf, wobei weitere Elemente außer Si, O, C, H einen Gehalt kleiner 10 at%, vorzugsweise kleiner 5 at% aufweisen. Diese Verbindung weist eine Zusammensetzung $SiO_xC_yH_z$ auf, bei welcher x kleiner 1 beträgt. Die Einheit at% gibt dabei, ähnlich wie Mol-Prozent die jeweiligen Stoffmengenanteile der Elemente an, wobei der Stoffmengenanteil der Elemente bei der Einheit at% unabhängig davon ist, in welcher Verbindung die Elemente vorliegen.

Insbesondere wurde bei besonderes beständigen und hydrophoben Beschichtungen gefunden, daß hier die Verbindung eine Zusammensetzung $SiO_xC_yH_z$ mit x kleiner 1 aufweist. Hier kann x in Weiterbildung der Erfindung insbesondere im Bereich von 0,6 bis 0,9, vorzugsweise im Bereich von 0,7 bis 0,8 liegen. Für besonders beständige Schichten haben sich weiterhin auch

Zusammensetzungsbereiche mit y im Bereich von 1,2 bis 3,3, vorzugsweise im Bereich von 1,5 bis 2,5 als günstig erwiesen.

Um eine derartige Beschichtung abzuscheiden, ist erfindungsgemäß ein Verfahren zur Herstellung eines medizinischen Packmittels vorgesehen, bei welchem eine Beschichtung mittels plasmaunterstützter chemischer Dampfphasenabscheidung auf dem Substrat abgeschieden wird, wobei zur Abscheidung ein Prozessgas mit einem siliziumhaltigen Gasbestandteil, sowie Kohlenstoff und Sauerstoff als weiteren Gasbestandteilen in einen Reaktionsraum eingelassen wird, der durch das Substrat zumindest teilweise begrenzt wird, und durch gepulste Einstrahlung elektromagnetischer Energie ein Plasma im Reaktionsraum gezündet wird, wodurch sich im Plasma Reaktionsprodukte bilden, die sich als Beschichtung auf dem Substrat abscheiden, wobei die Schicht, bei einer mehrlagigen Schicht die oberste Schicht, eine Zusammensetzung der Form $SiO_xC_yH_z$ aufweist, bei welcher x kleiner 1 beträgt, und wobei weitere Elemente außer Fluor und Silizium einen Gehalt kleiner 10 at%, vorzugsweise kleiner 5 at% aufweisen.

Die plasmaunterstützte chemische Dampfphasenabscheidung hat sich als verläßlich zur Herstellung der erfindungsgemäßen Beschichtungen erwiesen. Es wird allerdings nicht ausgeschlossen, daß sich auch andere chemische oder physikalische Dampfphasen-Abscheideverfahren zur Herstellung der Schichten eignen.

Ein Verbundmaterial, wie es mit dem oben beschriebenen Verfahren herstellbar ist, kann insbesondere auch mit einem Verfahren dargestellt werden, bei welchem die Beschichtung mittels plasmaunterstützter chemischer Dampfphasenabscheidung auf dem Substrat abgeschieden wird, wobei zur Abscheidung ein Prozessgas mit einem siliziumhaltigen Gasbestandteil, sowie Kohlenstoff und Sauerstoff als weiteren Gasbestandteilen in einen Reaktionsraum eingelassen wird, der durch das Substrat zumindest teilweise begrenzt wird, und durch gepulste Einstrahlung elektromagnetischer Energie ein Plasma im Reaktionsraum gezündet wird, wodurch sich im Plasma Reaktionsprodukte bilden, die sich als Schicht auf dem Substrat abscheiden, wobei ein gepulstes Plasma mit Pulsdauern im Bereich von 0,1μs - 500μs, vorzugsweise 0,5μs - 100μs, besonders bevorzugt 1μs - 50μs verwendet wird. Typische Pulslängen herkömmlicher Verfahren liegen demgegenüber im Millisekunden-Bereich. Die Pulse, wie sie erfindungsgemäß eingesetzt werden, sind demgegenüber um mindestens einen Faktor 10 kürzer. Als mögliche Ursache dafür, daß sich mit den erfindungsgemäß eingesetzten kurzen Pulsen Schichten mit neuartigen Zusammensetzungen abscheiden lassen, wird die verkürzte Reaktionszeit im Plasma angesehen. Durch die kurzen Pulse wird so die Ausbildung bestimmter Reaktionsprodukte, insbesondere die Einstellung eines chemischen Gleichgewichts im Plasma unterdrückt.

Werden Silikonöle als hydrophobe Beschichtung aufgetragen, wie dies aus der US 2,504,482 A bekannt ist, so wird ein im allgemeinen fluider, nicht fest an das Substrat gebundener Film erhalten. Im Unterschied dazu wird erfindungsgemäß aufgrund der Dampfphasenabscheidung ein Kondensat, insbesondere ein Festkörperkondensat als Beschichtung erhalten. Diese Beschichtung ist im allgemeinen eine Festkörper-Schicht oder ein Polymerisat, wobei die Beschichtung auch an das Substrat gebunden oder zumindest fest an diesem haftend ist. Zudem kann insbesondere auch eine Vernetzung der Schichtbestandteile erzielt werden. Im Falle einer Abscheidung mittels eines Plasmas kann dabei die Schicht auch als Plasmapolymer charakterisiert werden.

Um die oben beschriebene Beschichtung mit der ungewöhnlichen Zusammensetzung mittels plasmainduzierter Dampfphasenabscheidung abscheiden zu können, eignet sich insbesondere ein Plasma, bei welchem mittels geeignet gewählter Prozessparameter eine minimierte Energiedichte im Plasma sichergestellt wird, welches dabei aber noch stabil zündet. Dieses Plasma ist insbesondere noch durch eine sehr schwache Emission mittels eines Photonen-empfindlichen Detektors, der in der Umgebung des Plasmas angebracht wird, noch nachweisbar. So erweist sich für die Herstellung der obersten Schicht ein Plasma-Prozess mit einem mittleren Energieeintrag pro Masse $\varepsilon_M$ in einem Bereich von $10^{-1}$ J/kg bis $10^9$ J/kg, vorzugsweise in einem Bereich von $10^2$ J/kg bis $5 \times 10^6$ J/kg als günstig, wobei der mittlere Energieeintrag pro Masse $\varepsilon_M$ definiert ist durch

$$\varepsilon_M = \frac{\overline{\dot{W}}}{\sum_i F_i \cdot \tilde{M}_i}, \text{ mit der mittleren Leistung}$$

$$\overline{\dot{W}} = \frac{\Delta t_{pd}}{\Delta t_{pd} + \Delta t_{pp}} \cdot W_p,$$

Dabei bezeichnen $\overline{\dot{W}}$ die mittlere Mikrowellenleistung, $F_i$ den Fluss der Komponente i des Prozessgasgemisches mit Komponenten: $O_2$, Precursor und gegebenenfalls ein Trägergas, $\tilde{M}_i$ die Molekularmasse der Komponente i, $\Delta t_{pb}$ die Pulsdauer, $\Delta t_{pt}$ die Pulspause und $W_p$ die Pulsleistung. Es wird davon ausgegangen, daß sich mit diesen Prozessparametern und einem geeignet gewählten Prozessgas, welches auch nicht notwendigerweise einen siliziumhaltigen Gasbestandteil, und/oder Kohlenstoff und/oder Sauerstoff als weitere Gasbestandteile enthält auch andere Beschichtungen mit ungewöhnlicher Zusammensetzung abscheiden lassen.

Bei dem gepulsten Plasma zwischen den Pulsen wird vorzugsweise stetig eine Pulspause ohne Einkopplung von Energie durchlaufen, die größer als die Pulsdauer ist, die vorzugsweise zwischen 0,1ms und 200ms, besonders bevorzugt zwischen 0,5ms und 100ms, ganz besonders bevorzugt zwischen 1ms und 50ms liegt. Die Pulspausen sind besonders bevorzugt von konstanter Länge. Auf diese Weise kann die Abscheidung mit einer konstant niedrigen zeitlich gemittelte Leistung erfolgen. Die Pulspausen müssen dazu nicht exakt gleich lang sein. Vielmehr kann eine gewisse Variation der Dauern der Pulspausen erfolgen. So können die Pulspausen etwa beispielsweise in ihrer Dauer um bis zu einen Faktor 2 schwanken. Das Verhältnis von Pulspausen zu Pulsdauern kann für die Erzielung geringer zeitlich gemittelter Leistungsdichten bei dennoch sicherer Zündung des Plasmas in Weiterbildung der Erfindung zumindest 5:1, vorzugsweise zumindest 10:1 betragen.

Mit den sehr geringen Leistungsdichten im Plasma kann die Abscheidung der Beschichtung mit der ungewöhnlichen Zusammensetzung aus einem Prozessgas mit ansonsten gewöhnlichen Precursor-Gasen erreicht werden. Damit können $SiO_xC_yH_z$-Beschichtungen mit x im Bereich von 0,0 bis 1,2, y im Bereich von 0,0 bis 6,0, und z im Bereich von 0,0 bis 6,0 abgeschieden werden. Insbesondere kann auch eine Fluor-freie Beschichtung erzeugt werden, die dennoch hochgradig hydrophob und darüber hinaus beständig gegen Einwirkungen, wie etwa beim Autoklavieren ist.

Unter einer Fluor-freien Beschichtung wird eine Beschichtung verstanden, die keinen signifikanten Fluor-Anteil enthält. Selbstverständlich kann aber nicht ausgeschlossen werden, daß beispielsweise durch Verunreinigungen des Prozessgases noch minimale Mengen an Fluor in der Beschichtung enthalten sein können.

Um die niedrigen Leistungsdichten für die Abscheidung bereitzustellen und dennoch ein gutes Zündverhalten des Plasmas im Prozessgas zu erreichen, ist es günstig, sehr kurze Pulse elektromagnetischer Strahlung, vorzugsweise mikrowellenpulse zu verwendet. So ist in Weiterbildung der Erfindung vorgesehen, ein gepulstes Plasma mit Pulsdauern im Bereich von 0,1µs - 500µs, vorzugsweise 0,5µs - 100µs, besonders bevorzugt 1µs - 50µs zu verwenden.

Um die Barrierewirkung der Beschichtung zu verbessern, kann gemäß einer vorteilhaften Weiterbildung der Erfindung zwischen der die oberste Schicht bildenden Beschichtung mit einer Verbindung mit den Elementen Si, C, O und H und dem Substrat eine anorganische Schicht eingebettet sein. Auch diese anorganische Schicht wird bevorzugt mittels plasmaunterstützter Dampfphasenabscheidung abgeschieden werden. Vorzugsweise weist diese Schicht eine Zusammensetzung der Form $SiO_{1,0-2,8}C_{0,0-0,5}$ > auf.

Ein hoher Silizium-Anteil in Relation zu Sauerstoff in der oberflächlichen Schicht kann insbesondere auch dadurch erreicht werden, indem ein hoher Anteil von Silizium-Precursor im Prozessgas eingesetzt wird. Bei der Verwendung Silizium-organischer Precursor wird deren Volumenanteil im Prozessgasgemisch dabei auf mehr als 10%, vorzugsweise mehr als 50%, besonders bevorzugt mehr als 95% eingestellt.

Die Erfindung ist für die Innenbeschichtung von Hohlkörpern vorgesehen, bei welcher auf der Innenseite des Hohlkörpers die hydrophobe Beschichtung aufgebracht ist, um etwa die Restentleerbarkeit zu verbessern. Andere Einsatzzwecke der Beschichtung sind leicht reinigbare Oberflächen.

Als Material für Hohlkörper kommen insbesondere Glas oder Polymere, beziehungsweise Kunststoffe in Betracht. Vorzugsweise wird die Erfindung zur Beschichtung von PharmaPackmitteln, wie beispielweise Fläschchen, Spritzen oder Karpulen oder Komponenten für ein Pharma-Packmittel, wie beispielsweise Nadeln oder Stopfen eingesetzt. Geeignete Kunststoffe sind unter anderem COC (Cyclo-Olefin-Copolymer) und COP (Cyclo-Olefin-Polymer), auf denen eine gute Haftung der Schicht erzielt wird. Als Glas ist unter anderem Borosilikatglas gut geeignet.

Mittels der Erfindung kann die Restentleerbarkeit eines Hohlkörpers als Substrat im Vergleich zum unbeschichteten Hohlkörper nachweisbar verbessert werden. Dies äußert sich auch am Ablaufverhalten des beschichteten Hohlkörpers im Vergleich zum unbeschichteten Hohlkörper, welches derart verbessert werden kann, dass ein mit Flüssigkeit halb befüllter, verschlossener Hohlkörper nach Schütteln der Flüssigkeit und unmittelbar nach einer Ablaufdauer von 5s im Bereich der Innenoberfläche oberhalb der Flüssigkeit einen geringeren Flächenanteil von weniger als 50%, vorzugsweise wenige als 20% an anhaftender Flüssigkeit aufweist als ein unbeschichteter Hohlkörper. Gemäß einem weiteren Aspekt der Erfindung ist daher allgemein ein Verbundmaterial in Form eines innenbeschichteten Hohlkörpers vorgesehen, bei welchem die Restentleerbarkeit im Vergleich zum unbeschichteten Hohlkörper nachweisbar verbessert ist, und/oder das Ablaufverhalten des beschichteten Hohlkörpers im Vergleich zum unbeschichteten Hohlkörper derart verbessert ist, dass ein mit Flüssigkeit halb befüllter, verschlossener Hohlkörper nach Schütteln der Flüssigkeit und unmittelbar nach einer Ablaufdauer von 5s im Bereich der Innenoberfläche oberhalb der Flüssigkeit einen geringeren Flächenanteil von weniger als 50%, vorzugsweise weniger als 20% an anhaftender Flüssigkeit aufweist als ein unbeschichteter Hohlkörper.

Die Beschichtung kann gemäß einem weiteren Aspekt der Erfindung derart hydrophob hergestellt werden, daß ein Verbundmaterial mit einem Substrat und einer darauf abgeschiedenen Beschichtung erhalten wird, bei welchem die Beschichtung

a) einen Kontaktwinkel für Wasser von >= 100˚ besitzt,
oder
b) einen Ablaufwinkel <90˚, vorzugsweise < 50˚, besonders bevorzugt < 30˚ für einen Wassertropfen mit einem Volumen von 26 μl aufweist.

Die Beschichtung zeichnet sich weiterhin besonders vorteilhaft auch durch ihre verbesserte Beständigkeit gegen verschiedene Einflüsse auf, wie sie bei der Verpackung von Pharmapackmittel auftreten können. So konnte festgestellt werden, daß bei einer erfindungsgemäße Beschichtung durch einen der folgenden Sterilisationstests

i) einem Autoklaviertest bei 121˚C, 30Min.,
ii) Depyrogenisieren bei 300˚C, 20Min.,
iii) Gamma-Sterilisation mit 25kGy,
iv) einer Elektronenstrahl-Sterilisation mit 25 kGy, oder v) einer Ethylenoxid-Sterilisation (ETO-Sterilisation)

- der Kontaktwinkel der Beschichtung für Wasser um weniger als 4˚, vorzugsweise um weniger als 3˚, besonders bevorzugt um weniger als 1˚ verändert wird, und/oder
- der Ablaufwinkel für einen Wassertropfen mit einem Volumen von 26μl um weniger als 30˚, vorzugsweise weniger als 20˚, besonders bevorzugt um weniger als 10˚ verändert wird. Gemäß einem weiteren Aspekt der Erfindung wird daher allgemein ein Verbundmaterial, vorzugsweise in Form eines Behälters bereitgestellt, welches ein Substrat und eine darauf abgeschiedene Beschichtung umfasst, wobei die Beschichtung jeweils zumindest eines, vorzugsweise alle der vorstehend genannten Merkmale i) bis v) aufweist.

Auch zeigt eine solche Beschichtung eine hohe Lagerungsbeständigkeit. So konnte gezeigt werden, daß nach Lagertest des Verbundmaterials mit einer wässrigen Flüssigkeit in Kontakt mit der Schichtoberfläche nach einer Lagerdauer von 2 Wochen bei 60˚C die oben genannten Merkkmale der Beschichtung immer noch erfüllt werden. Demgemäß weist eine solche Schicht nach dem Lagertest folgende Eigenschaften auf:

- der Kontaktwinkel der Schicht für Wasser wird um weniger als 4˚, vorzugsweise um weniger als 3˚, besonders bevorzugt um weniger als 1˚ gegenüber dem Kontaktwinkel vor dem Lagertest verändert,
- der Ablaufwinkel für einen Wassertropfen mit einem Volumen von 26μl wird um weniger als 30˚, vorzugsweise weniger als 20˚, besonders bevorzugt um weniger als 10˚ gegenüber dem Ablaufwinkel vor dem Lagertest verändert,
- die Beschichtung zeigt immer noch einen Ablaufwinkel <90˚, vorzugsweise < 50˚, besonders bevorzugt < 30˚ für einen Wassertropfen mit einem Volumen von 26 μl,
- der Kontaktwinkel für Wasser ist immer noch >= 90˚,

vorzugsweise >= 100˚. Gemäß noch einem weiteren Aspekt der Erfindung ist daher ein Verbundmaterial mit einem Substrat und einer darauf abgeschiedenen Beschichtung, vorzugsweise in Form eines innenbeschichteten Behälters vorgesehen, deren Beschichtung die vorgenannten Merkmale nach dem Lagertest aufweist.
Um eine gute Anhaftung der Beschichtung zu erzielen, hat es sich weiterhin als besonders günstig erwiesen, wenn das Substrat vor der Abscheidung der Schicht aufgeheizt wird, vorzugsweise auf eine Temperatur zwischen 40˚C und 300˚C, besonders bevorzugt auf eine Temperatur zwischen 60˚C und 200˚C. Das Aufheizen kann insbesondere auch mittels eines Plasmas erfolgen. Auf diese Weise kann einerseits auf eine zusätzliche Heizeinrichtung verzichtet werden, andererseits kann durch die Plasmabehandlung gleichzeitig eine Aktivierung der Oberfläche erfolgen, was die Schichthaftung weiter verbessert. So ist in Weiterbildung der Erfindung vorgesehen, daß das Substrat mit einem Plasmaprozess unter Verwendung eines Edelgases, wie Argon, oder eines Inertgases, wie Stickstoff, oder eines sauerstoffhaltigen Gases, wie Sauerstoff, oder eines stickstoffhaltigen Gases, wie Ammoniak, aufgeheizt wird.
Alternativ oder zusätzlich kann eine Aufheizung aucu außerhalb des Beschichtungsreaktors, vorzugsweise mit einem Infrarotstrahler, aufgeheizt werden. Eine derartige Weiterbildung der Erfindung ist unter anderem für Beschichtungsanlagen mit hohen Durchsätzen von Vorteil. Mittels einer externen Aufheizung kann so die Prozesszeit der Vakuumprozesse vorteilhaft verkürzt werden.
Die gemittelte Leistung, die für die Plasmaabscheidung verwendet wird, ist erfindungsgemäß sehr niedrig. Es ist daher allgemein günstig, wenn die verwendete mittlere Leistung für den Aufheizprozess höher als für den Beschichtungsprozess ist. Dies äußert sich auch darin, daß die Lichtemission des Plasmas bei der Abscheidung der Beschichtung gemittelt über die Zeit geringer als die Lichtemission des Aufheizplasmas gemittelt über die Zeit ist. Demgemäß sieht die Erfindung als weiteren Aspekt ein Verfahren zur Herstellung eines Verbundmaterials vor, bei welchem das Substat vor Abscheidung der Beschichtung mit einem Plasmaprozess unter Verwendung eines Edelgases, wie Argon, oder eines Inertgases, wie Stickstoff, oder eines sauerstoffhaltigen Gases, wie Sauerstoff, oder eines stickstoffhaltigen Gases, wie Ammoniak, aufgeheizt wird und anschließend ebenfalls in einem Plasmaprozess mit gepulstem Plasma die Beschichtung abgeschieden wird, wobei die Lichtemission des Plasmas bei der Abscheidung der Beschichtung dabei um wenigstens einen Faktor 10 geringer, vorzugsweise um wenigstens einen Faktor $10^2$, besonders bevorzugt sogar um wenigstens einen Faktor $10^3$ geringer ist. Für eine gute Zündung des Plasmas bei der Abscheidung der Beschichtung ist es außerdem besonders günstig, wenn die Gaswechselzeit zwischen dem Aufheiz- und Beschichtungsprozess möglichst klein ist. Insbesondere kann die Gaswechselzeit geringer als 60s, vorzugsweise geringer als 30s, besonders bevorzugt geringer als 15s sein. Auch wird auf diese Weise die Aufheizung der Substratoberfläche aufrechterhalten.

Um die Beschichtung mit der obengenannten Zusammensetzung zu erhalten, wird die Beschichtung durch Plasmaabscheidung mit einem Prozessgas mit einer Kohlenstoff- und Siliziumhaltigen Ausgangsverbindung, einer Silizium-organischen Ausgangsverbindung, durchzuführen. Hierzu werden Prozessgases verwendet, welche wenigstens einen der Bestandteile Hexamethyldisiloxan, Tetramethyldisiloxan, Hexamethyldisilazan, TMCTS, TMDSN, TMS enthalten.

Da die Beschichtung zumindest einen Teil der Oberfläche darstellt und eine dauerhafte Hydrophobierung erzeugt wird, ist es weiterhin besonders bevorzugt, ein Endprodukt mit der Beschichtung als Teil der Oberfläche, beziehungsweise als oberster Schicht bereitzustellen. Im Falle von beschichteten Hohlkörpern als Verbundmaterial kann dies sowohl ein befüllter, als auch ein befüllfertiger Behälter sein. Bei Pharmapackmitteln können sich vor dem Einfüllen des Pharmazeutikums noch weitere Behandlungsschritte anschließen. Beispielsweise kann eine Lyophilierung erfolgen. Ebenso kann der Behälter gegebenenfalls zusätzlich sterilisiert werden. Schließlich können die hergestellten Verbundmaterialien auch zusätzlich, je nach Anwendungsfall leer oder befüllt, gegebenenfalls auch steril verpackt werden.

Die Erfindung wird nachfolgend anhand von Ausführungsbeispielen und unter Bezugnahme auf die beigeschlossene Figur näher erläutert.

Die Figur zeigt ein Pulsdiagramm von für die Schichtabscheidung verwendeten Mikrowellen-Pulsen, wobei die Mikrowellenintensität I gegen die Zeit t aufgetragen ist. Die Pulsdauern $t_1$ der Pulse sind sehr kurz mit Pulsdauern im Bereich von 0,5 $\mu$s bis höchstens 100 $\mu$s. Die Dauern $t_2$ der Pulspausen zwischen den einzelnen Pulsen werden demgegenüber wesentlich länger gewählt, wobei vorzugsweise Pulspausen mit Längen zwischen 0,5 und 100 Millisekunden eingestellt werden. Jedenfalls sollte das Verhältnis der Dauern $t_2/t_1$ zumindest 5:1, vorzugsweise zumindest 10:1 betragen.

Im Folgenden werden in Kurzform besonders günstige Varianten des erfindungsgemäßen Abscheideprozesses erläutert.

1. Prozessvariante:

Das oder die Substrate werden vorgeheizt, bevorzugt mit einem Plasma (02, N2, NH3, Edelgas), besonders bevorzugt hierbei mit einem Argon-Plasma. Das Vorheizen erfolgt auf eine Oberflächentemperatur im Bereich von 40˚C-300˚C, bevorzugt 60˚C-200˚C.

Für die Abscheidung der hydrophoben Beschichtung wird eine hohe Konzentration an Silizium-organischem Precursor im Prozessgas eingesetzt. Hierbei werden insbesondere mehr als 10%, vorzugsweise mehr als 50%, besonders bevorzugt sogar mehr als 95% Anteil des Silizium-organischem Precursors im Prozessgas verwendet. Die Abscheidung erfolgt dabei nach einer Gaswechselzeit von kürzer als 30s nach der Aufheizphase, vorzugsweise kleiner 15s, d.h. möglichst unmittelbar nach dem Aufheizen. Durch einen Restgas-Anteil an Prozessgas aus dem Aufheizprozess wird dadurch die Zündung des Plasmas für den Beschichtungsprozess erleichtert.

Die Schichtabscheidung erfolgt in zwei Stufen. Zunächst wird eine sehr dünne Schicht bei höherer Leistung abgeschieden, wodurch eine verbesserte Plasma-Zündung für die nachfolgende Schicht erzielt wird, als wenn auf diese erste Schicht verzichtet wird. Die zweite Schicht wird dann dementsprechend bei niedrigerer Leistung abgeschieden. Für die Abscheidung werden sehr kurze Pulse mit Pulsdauern im Bereich von 0,1$\mu$s - 500$\mu$s, vorzugsweise 0,5$\mu$s - 100$\mu$s, besonders bevorzugt 1$\mu$s - 50$\mu$s eingesetzt.

2. Prozessvariante:

Es wird eine Kombinationsschicht aus einer Barriere-Schicht, insbesondere mit Barriere gegen Alkali-Auslaugung und einer erfindungsgemäßen, darauf aufgebrachten Beschichtung hydrophober Oberfläche hergestellt. Durch diese Kombinationsschicht wird sowohl eine Auslaugung von Substanzen aus dem Substrat (z.B. Ionenauslaugung aus Glas) reduziert als auch eine gute Restentleerbarkeit und ein gutes Ablaufverhalten erzielt. Das Abscheiden dieser Kombinationsschicht wird in einem kontinuierlichen Prozess durchgeführt.

Zunächst wird der Reaktionsraum abgepumpt. Anschließend erfolgt ein Aufheizen des Substrats, vorzugsweise mit einem Sauerstoff- oder Argon-Plasma auf eine Temperatur T > 150˚C, vorzugsweise > 200˚C. Nachfolgend wird eine Barriere-Schicht mit einem Gemisch aus Silizium-organischem Precursor und Sauerstoff abgeschieden, wobei die Precursor-Konzentration im Prozessgasgemisch bei kleiner 20%, vorzugsweise kleiner 10% liegt. Nachfolgend erfolgt eine Abkühlphase, während der die Temperatur mindestens um 20˚C, vorzugsweise mindestens um 50˚C abfällt. Nach der Abkühlphase wird Prozessgas, vorzugsweise Argon eingelassen und ein Plasma gezündet. In dieser erneuten kurzen Aufheizphase wird das Substrat auf die Solltemperatur gebracht. Es erfolgt dann ein Gaswechsel auf einen Prozessgasgemisch mit Silizium-organischen Precursor. Mit der erneuten Plasmazündung wird eine erfindungsgemäße hydrophobe Beschichtung abgeschieden. Anschließend erfolgt ein Fluten auf Atmosphärendruck.

3. Prozessvariante:

Diese Variante ähnelt der vorstehend beschriebenen 2. Prozessvariante, allerdings erfolgt der Beschichtungsprozess diskontinuierlich. Zur Abscheidung der ersten Schicht, die eine Barriereschicht darstellt, wird der Reaktionsraum abgepumpt, das Substrat in einem Plasma, vorzugsweise einem Sauerstoff- oder Argon-Plasma auf eine Temperatur T > 150˚C, vorzugsweise > 200˚C aufgeheizt und anschließend in einer Prozessgas-Atmosphäre mit einem Gemisch aus Silizium-organischem Precursor und Sauerstoff mit einer Precursor-Konzentration kleiner 20%, vorzugsweise kleiner 10% die Barrierebeschichtung abgeschieden. Nach der Abscheidung wird der Reaktionsraum auf Atmosphärendruck geflutet.

Der Reaktionsraum wird wieder abgepumpt und anschließend in einem Plasma, vorzugsweise unter Verwendung von Argon als Prozessgas das Substrat in einem kurzen Aufheizprozess auf Solltemperatur gebracht. Es erfolgt ein Gaswechsel auf ein Gasgemisch mit Silizium-organischem Precursor zur Abscheidung der erfindungsgemäßen hydrophoben Beschichtung und eine Plasma-Zündung. Nach Abscheidung der Schicht wird der Reaktionsraum auf Atmosphärendruck geflutet.

Im folgenden werden einige detaillierte Ausführungsbeispiele beschrieben.

Ausführungsbeispiel 1, hydrophobe Innen-Beschichtung von Vials

a) Ein Vial aus Borosillicat-Glas (SCHOTT-Fiolax), 14ml Randvoll-Volumen, wird in Reaktor eingesetzt. Dabei liegt das Vial zunächst auf der Unterseite des Reaktors auf einer Dichtfläche. Anschließend wird die Oberseite des Reaktors zugefahren und der Innenraum des Vials evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird ein Gaseinlass-Ventil geöffnet und über die Gaszuführung als erstes Prozessgas Sauerstoff eingeleitet. Mittels einer Mikrowellenquelle wird anschließend gepulste Mikrowellen-Energie mit einer Frequenz von 2,45 GHz eingeleitet und ein Plasma gezündet. Das Substrat wird mit dem Plasma auf eine Temperatur von 250˚C aufgeheizt. Nachfolgend wird in einer Gaswechselzeit ein Gemisch aus Hexamethyldisiloxan und Sauerstoff eingeleitet und eine 100nm dicke, glasartige SiOx-Schicht abgeschieden. Anschließend wird die Anlage geflutet und das Fläschchen auf Raumtemperatur abgekühlt.

Nachfolgend wird der Innenraum des Vials auf einen Basisdruck < 0,05mbar wiederum evakuiert und es wird als drittes Prozessgas Argongas mit einem Fluss von 86,5sccm und bei einem Druck von 0,5mbar eingeleitet. Erst ab dem Zeitpunkt, sobald gepulste Mikrowellen-Energie von der Mikrowellenquelle mit einer Frequenz von 2,45 GHz mit einer mittleren Mikrowellenleistung von 900W über den Wellenleiter in den Reaktorraum eingekoppelt wird, zündet im Innenraum des Vials ein Plasma während außenseitig aufgrund des Atmosphärendrucks kein Plasma zündet. Das Vial wird während des Vorgangs für eine erste Behandlungsdauer von 61s auf eine Temperatur von 150˚C aufgeheizt. Gegen Ende der ersten Plasma-Behandlung wird die Mikrowellen-Energie gestoppt. Anschließend folgt eine Gaswechselzeit, in der ein viertes Gasgemisch aus Hexamethyldisiloxan mit einem HMDSO-Fluss von 15sccm bei einem Druck von 0,2mbar in den Innenraum des Vials geleitet wird. Sobald gepulste Mikrowellen-Energie von der Mikrowellenquelle mit einer Frequenz von 2,45 GHz mit einer mittleren Mikrowellenleistung von 2,4W und einer Pulsdauer von 12$\mu$s sowie einer Pulspause 10ms, Pulsleistung 2000W über den Wellenleiter in den Reaktorraum eingeleitet wird, zündet innen im Vial ein Plasma und es wird für eine Beschichtungsdauer von 90,2s eine Silizium-organische, hydrophobe Schicht mit einer mittleren Schichtdicke von 40nm aufgebracht. Gegen Ende des Beschichtungsvorgangs wird die Mikrowellen-Energie gestoppt, die Zufuhr des Prozessgases wird unterbrochen und der Innenraum des Vials wird bis auf Atmosphärendruck geflutet.

i) Ohne Belastungstest zeigt das so beschichtete Vial folgende Eigenschaften:

a) Kontaktwinkel:

Eine Messung des Kontaktwinkels für Wasser ergibt für beschichtete Vials einen Wert von 110˚±2˚. Die Schichten sind somit stark hydrophob.

b) Hohe Restentleerbakeit:

Ferner weisen die beschichteten Vials eine deutlich verbesserte Restentleerbarkeit im Vergleich zu unbeschichteten Fiolax-Vials auf: Unbeschichtete und beschichtete Vials werden gewogen und anschließend mit 10ml Wasser befüllt. Mittels einer am Flaschenboden angesetzten Spritzenkanüle werden die Fläschchen soweit entleert, dass nur noch das an der Behälterwand anhaftendes Restvolumen im Behälter verbleibt. Nach Entnahme der Flüssigkeit werden die Fläschchen wiederum gewogen. Aus der Differenz zwischen dem Gewicht des Fläschchens nach Entleeren und dem Gewicht des unbefüllten Fläschchens wird das Gewicht für die im Fläschchen verbliebene Restmenge bestimmt.

Es ergibt sich für ein unbeschichtetes Fläschchen eine Restmenge mit einem Gewicht von 15,3mg, für hydrophob beschichtete Fläschchen dagegen eine Restmenge mit einem Gewicht, das unterhalb des Messfehlers von 10,4mg liegt.

c) Gutes zeitliches Ablaufverhalten

Die beschichteten Vials weisen ein gutes zeitliches Ablaufverhalten für Wasser auf:
Sie werden mit 10ml Wasser, das zwecks besserer Visualisierung mit einem weißen Farbstoff eingefärbt ist, befüllt und geschüttelt. Nach Schütteln haften nach einer Ablaufzeit von 2s keine oder nur wenige Tropfen an der Behälterwand (Flächenanteil < 10%) während bei unbeschichteten Fiolax Vials noch ein Wassserfilm bzw. Tropfen an der Oberfläche anhaften und der Flächenanteil höher als 50% liegt.

d) Ablaufwinkel

Der Ablaufwinkel für Tröpchen mit einem Volumen von 26μl liegt bei 20˚.

ii) Eigenschaften nach Autoklavier-Test:

Nach Heißdampf-Sterilisation (Autoklavier-Test) mit destilliertem Wasser bei 121˚C, 30 Minuten ergeben sich folgende Eigenschaften:

a) Kontaktwinkel

Nach Autoklavier-Test bleibt der Kontaktwinkel unverändert bei 110˚±2˚. Folglich sind die Schichten sehr beständig gegenüber dem Autoklavieren, da keine Änderung im Kontaktwinkel nachweisbar ist.

b) Hohe Restentleerbarkeit

Für hydrophob beschichtete Fläschchen ergibt sich nach Autoklavier-Test bei der Bestimmung der Restentleerbarkeit eine Restmenge mit einem Gewicht unterhalb des Messfehlers von 10,4mg. Folglich bleibt die Produkt-Eigenschaft einer hohen Restentleerbarkeit auch nach Autoklavier-Test bestehen.

c) Gutes zeitliches Ablaufverhalten

Die beschichteten Vials weisen auch nach Autoklavier-Test ein gutes zeitliches Ablaufverhalten für Wasser auf: Nach Schütteln haften nach einer Ablaufzeit von 2s keine oder nur wenige Tropfen an der Behälterwand (Flächenanteil < 10%).

iii) Eigenschaften nach Depyrogenisieren:

Nach Depyrogenisieren von hydrophob beschichteten Vials, getestet mittels einer Ofenlagerung bei 300˚C, 30 Minuten an trockener Luft, ergibt sich:

a) Hohe Restentleerbarkeit:

Für hydrophob beschichtete Fläschchen ergibt sich nach Depyrogenisieren bei der Bestimmung der Restentleerbarkeit eine Restmenge mit einem Gewicht unterhalb des Messfehlers von 10,4mg. Folglich bleibt die Produkt-Eigenschaft einer hohen Restentleerbarkeit auch nach Depyrogenisieren bestehen.

b) Gutes zeitliches Ablaufverhalten:

Die beschichteten Vials weisen auch nach Depyrogenisieren ein gutes zeitliches Ablaufverhalten für Wasser auf: Nach Schütteln haften nach einer Ablaufzeit von 2s keine oder nur wenige Tropfen an der Behälterwand (Flächenanteil < 10%).

iv) Abriebbeständigkeit der Beschichtung:

Hydrophob beschichtete Vials werden mit Wasser befüllt und in einer Apparatur mit 200 Hüben während einer Dauer von 1 Minute geschüttelt.

a) Hohe Restentleerbarkeit:

Nach Schütteltest ergibt sich bei der Bestimmung der Restentleerbarkeit eine Restmenge mit einem Gewicht unterhalb des Messfehlers von 10,4mg.

b) Gutes zeitliches Ablaufverhalten:

Nach Schütteltest besitzen die Vials immer noch ein gutes Ablaufverhalten. Folglich sind die Schichten sehr abriebbeständig.

Ausführungsbeispiel 2, Analyse der Schichtzusammensetzung:

Mit dem gleichen Verfahren und den gleichen Prozessparametern wie beim Ausführungsbeispiel 1 werden Vials aus Borosillicat-Glas (SCHOTT-Fiolax) , 14ml Randvoll-Volumen beschichtet. Es wird jedoch eine dickere hydrophobe Schicht mit einer Schichtdicke von 100nm aufgebracht.
Mittel XPS-Analyse wird die Zusammensetzung der hydrophoben Schicht bestimmt. Es ergibt sich eine Zusammensetzung von: Si: 26,4 at-%, O: 19,8 at-%, C: 53,7 at-%. Somit ist das Verhältnis O/Si sehr niedrig und sogar überraschender Weise kleiner als 1. Der Kohlenstoff-Gehalt mit mehr als 50 at-% liegt dabei sehr hoch.
Demnach weist die Schicht eine Zusammensetzung $SiO_xC_yH_z$ mit y im Bereich von 1,2 bis 3,3, insbesondere im Bereich von 1,5 bis 2,5 und x im Bereich von 0,6 bis 0,9, insbesondere im Bereich von 0,7 bis 0,8 auf.

Ausführungsbeispiel 3, Hydrophobe Innen-Beschichtung von Vials

a) Ein Vial aus Borosillicat-Glas (SCHOTT-Fiolax),.Typ 2R, 4ml Randvoll-Volumen, wird in einen Reaktor zugeführt. Dabei liegt das Vial zunächst auf der Unterseite des Reaktors auf der Dichtfläche. Anschließend wird die Oberseite des Reaktors zugefahren und der Innenraum des Vials evakuiert bis ein Basisdruck < 0,05mbar erreicht wird. Der Außenraum bleibt während des gesamten Behandlungsvorgangs auf Atmosphärendruck. Während untenseitig die Verbindung zum Vakuum beibehalten bleibt, wird ein Gaseinlass-Ventil geöffnet und über die Gaszuführung als erstes Prozessgas Sauerstoff eingeleitet. Mittels einer Mikrowellenquelle wird anschließend gepulste Mikrowellen-Energie mit einer Frequenz von 2,45 GHz eingeleitet und ein Plasma gezündet. Das Substrat wird mit dem Plasma auf eine Temperatur von 250˚C aufgeheizt. Nachfolgend wird in einer Gaswechselzeit ein Gemisch aus Hexamethyldisiloxan und Sauerstoff eingeleitet und eine 100nm dicke, glasartige SiOx-Schicht abgeschieden. Anschließend wird die Anlage geflutet und das Fläschchen auf Raumtemperatur abgekühlt.

Nachfolgend wird der Innenraum des Vials auf einen Basisdruck < 0,05mbar wiederum evakuiert und es wird als drittes Prozessgas Argongas mit einem Fluss von 86,5sccm und bei einem Druck von 0,5mbar eingeleitet. Erst ab dem Zeitpunkt, sobald gepulste Mikrowellen-Energie von der Mikrowellenquelle mit einer Frequenz von 2,45 GHz mit mittleren Mikrowellenleistung von 500W über den Wellenleiter in den Reaktorraum eingekoppelt wird, zündet im Innenraum des Vials ein Plasma während außenseitig aufgrund des Atmosphärendrucks kein Plasma zündet. Das Vial wird während des Vorgangs für eine erste Behandlungsdauer von 30s auf eine Temperatur von 80˚C aufgeheizt. Gegen Ende der ersten Plasma-Behandlung wird die Mikrowellen-Energie gestoppt. Anschließend folgt eine Gaswechselzeit, in der ein zweites Gasgemisch aus Hexamethyldisiloxan mit einem HMDSO-Fluss von 15sccm bei einem Druck von 0,1mbar in den Innenraum des Vials geleitet wird. Sobald gepulste Mikrowellen-Energie von der Mikrowellenquelle mit einer Frequenz von 2,45 GHz mit einer Pulsdauer von 100μs sowie einer Pulspause 60ms und einer Pulsleistung 900W über den Wellenleiter in den Reaktorraum eingeleitet wird, zündet innen im Vial ein Plasma und es wird für eine Beschichtungsdauer von 95s eine Silizium-organische, hydrophobe Schicht aufgebracht. Gegen Ende des Beschichtungsvorgangs wird die Mikrowellen-Energie gestoppt, die Zufuhr des Prozessgases wird unterbrochen und der Innenraum des Vials wird bis auf Atmosphärendruck geflutet.

i)Eigenschaften ohne Belastungstest:

a) Hohe Restentleerbakeit:

Die hydrophob beschichteten Vials weisen eine deutlich verbesserte Restentleerbarkeit im Vergleich zu unbeschichteten Fiolax-Vials auf: Unbeschichtete und beschichtete Vials werden gewogen und anschließend mit 4ml Wasser befüllt. Mittels einer am Flaschenboden angesetzten Spritzenkanüle werden die Fläschchen soweit entleert, dass nur noch das an der Behälterwand anhaftendes Restvolumen im Behälter verbleibt. Nach Entnahme der Flüssigkeit werden die Fläschchen wiederum gewogen. Aus der Differenz zwischen dem Gewicht des Fläschchens nach Entleeren und dem Gewicht des unbefüllten Fläschchens wird das Gewicht für die im Fläschchen verbliebene Restmenge bestimmt.
Es ergibt sich für ein unbeschichtetes Fläschchen eine Restmenge mit einem Gewicht von 18,0 mg, für hydrophob beschichtete Fläschchen dagegen eine Restmenge mit einem Gewicht, das unterhalb des Messfehlers von 10,4mg liegt.

b) Gutes zeitliches Ablaufverhalten:

Die beschichteten Vials weisen ein gutes zeitliches Ablaufverhalten für Wasser auf. Sie werden mit 10ml Wasser, das zwecks besserer Visualisierung mit einem weißen Farbstoff eingefärbt ist, befüllt und geschüttelt. Nach Schütteln haften nach einer Ablaufzeit von 2s keine oder nur wenige Tropfen an der Behälterwand (Flächenanteil < 10%) während bei unbeschichteten Fiolax Vials noch ein Wassserfilm bzw. Tropfen an der Oberfläche anhaftet und der Flächenanteil höher als 50% liegt.

c) Ablaufwinkel:

Der Ablaufwinkel für Tröpchen mit einem Volumen von 26μl liegt bei 20˚.

ii) Eigenschaften nach Autoklavier-Test:

Nach Heißdampf-Sterilisation (Autoklavier-Test) mit destilliertem Wasser.bei 121˚C, 30 Minuten ergeben sich folgende Eigenschaften:

a) Kontaktwinkel:

Nach Autoklavier-Test bleibt der Kontaktwinkel unverändert bei 110˚±2˚. Folglich sind die Schichten sehr beständig gegenüber dem Autoklavieren, da keine Änderung im Kontaktwinkel nachweisbar ist.

b) Hohe Restentleerbarkeit:

Für hydrophob beschichtete Fläschchen ergibt sich nach Autoklavier-Test bei der Bestimmung der Restentleerbarkeit eine Restmenge mit einem Gewicht unterhalb des Messfehlers von 10,4mg. Folglich bleibt die Produkt-Eigenschaft einer hohen Restentleerbarkeit auch nach Autoklavier-Test bestehen.

c) Gutes zeitliches Ablaufverhalten:

Die beschichteten Vials weisen auch nach Autoklavier-Test ein gutes zeitliches Ablaufverhalten für Wasser auf: Nach Schütteln haften nach einer Ablaufzeit von 2s keine oder nur wenige Tropfen an der Behälterwand (Flächenanteil < 10%) .

iii) Eigenschaften nach Depyrogenisieren:

Nach Depyrogenisieren von hydrophob beschichteten Vials, getestet mittels einer Ofenlagerung bei 300˚C, 30Minuten an trockener Luft, ergibt sich:

a) Hohe Restentleerbarkeit:

Für hydrophob beschichtete Fläschchen ergibt sich nach Depyrogenisieren bei der Bestimmung der Restentleerbarkeit eine Restmenge mit einem Gewicht unterhalb des Messfehlers von 10,4mg. Folglich bleibt die Produkt-Eigenschaft einer hohen Restentleerbarkeit auch nach Depyrogenisieren bestehen.

b) Gutes zeitliches Ablaufverhalten:

Die beschichteten Vials weisen auch nach Depyrogenisieren ein gutes zeitliches Ablaufverhalten für Wasser auf: Nach Schütteln haften nach einer Ablaufzeit von 2s keine oder nur wenige Tropfen an der Behälterwand (Flächenanteil < 10%).

iv) Abriebbeständigkeit der Beschichtung:

Hydrophob beschichtete Vials werden mit Wasser befüllt und in einer Apparatur mit 200 Hüben während einer Dauer von 1 Minute geschüttelt.

a) Hohe Restentleerbarkeit:

Nach Schütteltest ergibt sich bei der Bestimmung der Restentleerbarkeit eine Restmenge mit einem Gewicht unterhalb des Messfehlers von 10,4mg.

b) Gutes zeitliches Ablaufverhalten:

Nach Schütteltest besitzen die Vials immer noch ein gutes Ablaufverhalten. Folglich sind die Schichten sehr abriebbeständig.

Ausführungsbeispiel 4, Hydrophobe Einzelschicht:

Analog zum Ausführungsbeispiel wird die hydrophobe Einzelschicht hergestellt, auf die vorherige Abscheidung einer Barriere-Schicht allerdings verzichtet. Entsprechende Tests wie in Ausführungsbeispiel 2 ergeben, dass die beschichteten Vials die in Ausführungsbeispiel 2 genannten Eigenschaften ebenfalls aufweisen.

Es ist dem Fachmann ersichtlich, daß die Erfindung nicht auf die vorstehend beschriebenen Ausführungsbeispiele beschränkt ist, sondern vielmehr in vielfältiger Weise varriiert und die Merkmale der einzelnen Ausführungsbeispiele auch miteinander kombiniert werden können.

**Patentansprüche**

1. Medizinisches Packmittel mit einem Substrat, **dadurch gekennzeichnet, dass** das Substrat einen Hohlkörper, insbesondere einen Behälter, vorzugsweise ein Pharma-Packmittel umfasst, und einer auf dessen Innenseite abgeschiedenen Fluor-freien, hydrophoben Beschichtung, die zumindest einen Teil der Oberfläche des beschichteten Substrats formt, wobei die oberste Schicht als maßgeblichen Bestandteil eine Verbindung mit den Elementen Si, C, O und H enthält, wobei weitere Elemente außer Si, C, 0, H einen Gehalt kleiner 10 at%, vorzugsweise kleiner 5 at% aufweisen, dadurch gekenntzeichnet, dass die Verbindung eine Zusammensetzung $SiO_x$-$C_yH_z$ aufweist, bei welcher x kleiner 1 ist und die Beschichtung einen Kontaktwinkel für Wasser von $\geq 100˚$ besitzt.

2. Medizinisches Packmittel gemäß dem vorstehenden Anspruch, **dadurch gekennzeichnet, dass** x im Bereich von 0,6 bis 0,9, vorzugsweise von 0,7 bis 0,8 und y im Bereich von 1,2 bis 3,3, vorzugsweise im Bereich von 1,5 bis 2,5 liegt.

3. Medizinisches Packmittel gemäß einem der vorstehenden Ansprüche, **dadurch gekennzeichnet, dass** die Beschichtung ein Polymerisat, vorzugsweise ein vernetztes Polymerisat umfasst.

4. Medizinisches Packmittel gemäß einem der vorstehenden Ansprüche, **dadurch gekennzeichnet, dass** zwischen der die oberste Schicht bildenden Beschichtung mit einer Verbindung mit den Elementen Si, C, O und H und dem Substrat eine anorganische Schicht mit der Zusammensetzung $SiO_{1,0-2,8}C_{0,0-0,5}$ eingebettet ist, und die anorganische Schicht auf der Oberfläche des Substrates abgeschieden wird.

5. Medizinisches Packmittel gemäß einem der vorstehenden Ansprüche, **dadurch gekennzeichnet, dass** die Beschichtung einen Ablaufwinkel < 90˚, vorzugsweise < 50˚, besonders bevorzugt < 30˚ für einen Wassertropfen mit einem Volumen von 26 $\mu$l

aufweist.

**6.** Befüllter oder befüllfertiger Behälter mit einem Medizinischen Packmittel gemäß einem der vorstehenden Ansprüche.

**7.** Verfahren zur Beschichtung von medizinischen Packmitteln mit einem Substrat, **dadurch gekennzeichnet, dass** das Substrat einen Hohlkörper, insbesondere einen Behälter, vorzugsweise ein Pharma-Packmittel umfasst, und einer auf dessen Innenseite abgeschiedenen Fluor-freien, hydrophoben Beschichtung, die zumindest einen Teil der Oberfläche des beschichteten Substrats formt, wobei die oberste Schicht als maßgeblichen Bestandteil eine Verbindung mit den Elementen Si, C, O und H enthält, **dadurch gekennzeichnet, dass** die Verbindung eine Zusammensetzung $SiO_xC_yH_z$ aufweist, bei welcher x kleiner 1 ist und die Beschichtung einen Kontaktwinkel für Wasser von $\geq 100°$ besitzt, wobei weitere Elemente außer Si, C, O, H einen Gehalt kleiner 10 at%, vorzugsweise kleiner 5 at% aufweisen, bei welchem die Beschichtung mittels gepulster plasmaunterstützter chemischer Dampfphasenabscheidung auf dem Substrat abgeschieden wird, wobei zur Abscheidung ein Prozessgas mit wenigstens einem der Bestandteile Hexamethyldisiloxan, Tetramethyldisiloxan, Hexamethyldisilazan, TMCTS, TMDSN, TMS sowie Kohlenstoff und Sauerstoff als weitere Gasbestandteile in einen Reaktionsraum eingelassen wird, der durch das Substrat zumindest teilweise begrenzt wird, und durch gepulste Einstrahlung elektromagnetischer Energie ein Plasma im Reaktionsraum gezündet wird, wodurch sich im Plasma Reaktionsprodukte bilden, die sich als Schicht auf dem Substrat abscheiden, wobei ein gepulstes Plasma mit Pulsdauern im Bereich von $0{,}1\mu s$ - $500\mu s$, vorzugsweise $0{,}5\mu s$ - $100\mu s$, besonders bevorzugt $1\mu s$ - $50\mu s$ verwendet wird.

**8.** Verfahren nach vorstehendem Anspruch, **dadurch gekennzeichnet, dass** für die Herstellung der obersten Schicht ein Plasma-Prozess mit einem mittleren Energieeintrag pro Masse $\varepsilon_M$ in einem Bereich von $10^{-1}$ J/kg bis $10^9$ J/kg, vorzugsweise in einem Bereich von $10^2$ J/kg bis $5 \times 10^6$ J/kg verwendet wird, wobei der mittlere Energieeintrag pro Masse $\varepsilon_M$ definiert ist durch

$$\varepsilon_M = \frac{\overline{W}}{\sum_i F_i \cdot \tilde{M}_i}, \text{ mit der}$$

mittleren Leistung

$$\overline{W} = \frac{\Delta t_{pd}}{\Delta t_{pd} + \Delta t_{pp}} \cdot W_p,$$

wobei $\overline{W}$ die mittlere Mikrowellenleistung, $F_i$ den Fluss der Komponente i des Prozessgasgemisches mit Komponenten: $O_2$, Precursor und gegebenenfalls ein Trägergas, $\tilde{M}_i$ die Molekularmasse der Komponente i, $\Delta t_{pb}$ die Pulsdauer, $\Delta t_{pt}$ die Pulspause und $W_p$ die Pulsleistung bezeichnen.

**9.** Verfahren gemäß einem der vorstehenden Ansprüche **dadurch gekennzeichnet, dass** bei dem gepulsten Plasma zwischen den Pulsen stetig eine konstante Pulspause ohne Einkopplung von Energie durchlaufen wird, die größer als die Pulsdauer ist, die vorzugsweise zwischen 0,1ms und 200ms, besonders bevorzugt zwischen 0,5ms und 100ms, ganz besonders bevorzugt zwischen 1ms und 50ms liegt, wobei das Verhältnis von Pulspausen zu Pulsdauern zumindest 5:1, vorzugsweise zumindest 10:1 beträgt.

**10.** Verfahren gemäß einem der vorstehenden Ansprüche, **dadurch gekennzeichnet, dass** das Substrat vor der Abscheidung der Schicht mit einem Plasmaprozess unter Verwendung eines Edelgases, wie Argon, oder eines Inertgases, wie Stickstoff, oder eines sauerstoffhaltigen Gases, wie Sauerstoff, oder eines stickstoffhaltigen Gases, wie Ammoniak, oder außerhalb des Beschichtungsreaktors mit einem Infrarotstrahler, aufgeheizt wird, vorzugsweise auf eine Temperatur zwischen 40°C und 300°C, besonders bevorzugt auf eine Temperatur zwischen 60°C und 200°C

**11.** Verfahren gemäß Anspruch 10, **dadurch gekennzeichnet, dass** die Lichtemission des Plasmas bei der Abscheidung der Beschichtung gemittelt über die Zeit geringer als die Lichtemission des Aufheizplasmas gemittelt über die Zeit ist, dabei insbesondere um wenigstens einen Faktor 10 geringer ist, vorzugsweise um wenigstens einen Faktor $10^2$, besonders bevorzugt um wenigstens einen Faktor $10^3$ geringer liegt.

## Claims

**1.** Medical package having a substrate, **characterised in that** the substrate comprises a hollow body, in particular a container, preferably a pharmaceutical package, and a fluorine-free, hydrophobic coating deposited on the inner side thereof, the coating forming at least a part of the surface of the coated substrate, wherein the uppermost layer contains as the significant component a compound having the elements Si, C, O and H, wherein further elements other than Si, C, O, H have a content of less than 10 at. %, preferably less than 5 at.%, **characterised in that** the compound comprises a composition $SiO_xC_yH_z$, in which x is less than 1 and the coating has a contact angle for water of $\geq 100°$.

2. Medical package as claimed in the preceding claim, **characterised in that** x is in the range of 0.6 to 0.9, preferably 0.7 to 0.8 and y is in the range of 1.2 to 3.3, preferably in the range of 1.5 to 2.5.

3. Medical package as claimed in any one of the preceding claims, **characterised in that** the coating comprises a polymerisate, preferably a cross-linked polymerisate.

4. Medical package as claimed in any one of the preceding claims, **characterised in that** embedded between the coating, which forms the uppermost layer, comprising the compound with the elements Si, C, O and H and the substrate is an inorganic layer comprising the composition $SiO_{1.0-2.8}C_{0.0-0.5}$, and the inorganic layer is deposited on the surface of the substrate.

5. Medical package as claimed in any one of the preceding claims, **characterised in that** the coating has a drain angle < 90°, preferably < 50°, particularly preferably < 30° for a water droplet having a volume of 26 $\mu$l.

6. Filled or ready-to-fill container having a medical package as claimed in any one of the preceding claims.

7. Method of coating medical packages having a substrate, **characterised in that** the substrate comprises a hollow body, in particular a container, preferably a pharmaceutical package, and a fluorine-free, hydrophobic coating deposited on the inner side thereof, the coating forming at least a part of the surface of the coated substrate, wherein the uppermost layer contains as the significant component a compound having the elements Si, C, O and H, **characterised in that** the compound comprises a composition $SiO_xC_yH_z$, in which x is less than 1 and the coating has a contact angle for water of $\geq 100°$, wherein further elements other than Si, C, O, H have a content of less than 10 at.%, preferably less than 5 at.%, in which the coating is deposited on the substrate by means of pulsed plasma-assisted chemical vapour deposition, wherein for the deposition a process gas having at least one of the components hexamethyldisiloxane, tetramethyldisiloxane, hexamethyldisilazane, TMCTS, TMDSN, TMS and carbon and oxygen as further gas components is admitted into a reaction chamber which is bounded at least in part by the substrate, and a plasma in the reaction chamber is ignited by pulsed irradiation of electromagnetic energy, whereby in the plasma reaction products are formed which are deposited as a layer on the substrate, wherein a pulsed plasma having pulse durations in the range of 0.1 $\mu$s - 500 $\mu$s, preferably 0.5 $\mu$s - 100 $\mu$s, particularly preferably 1 $\mu$s - 50 $\mu$s is used.

8. Method as claimed in the preceding claim, **characterised in that** in order to produce the uppermost layer a plasma process is used with an mean energy input per mass $\varepsilon_M$ in a range of $10^{-1}$ J/kg to $10^9$ J/kg, preferably in a range of $10^2$ J/kg to $5 \times 10^6$ J/kg, wherein the mean energy input per mass $\varepsilon_M$ is defined by $\varepsilon_M = \dfrac{\overline{W}}{\sum_i F_i \cdot \widetilde{M}_i}$, with the mean power

$$\overline{W} = \frac{\Delta t_{pd}}{\Delta t_{pd} + \Delta t_{pp}} \cdot Wp,$$

where $\overline{W}$ designates the mean microwave power, $F_i$ designates the flow of the component i of the process gas mixture with components: $O_2$, precursor and optionally a carrier gas, $\widetilde{M}_i$ designates the molecular mass of the component i, $\Delta t_{pb}$ designates the pulse duration, $\Delta t_{pt}$ designates the pulse pause and $W_p$ designates the pulse power.

9. Method as claimed in any one of the preceding claims, **characterised in that** in the case of the pulsed plasma a constant pulse pause without energy coupled in is continuously run between the pulses, wherein the pulse pause is longer than the pulse duration which is preferably between 0.1 ms and 200 ms, particularly preferably between 0.5 ms and 100 ms, more particularly preferably between 1 ms and 50 ms, wherein the ratio of pulse pauses to pulse durations is at least 5:1, preferably at least 10:1.

10. Method as claimed in any one of the preceding claims, **characterised in that** prior to the deposition of the layer the substrate is heated with a plasma process using a noble gas, such as argon, or an inert gas, such as nitrogen, or an oxygen-containing gas, such as oxygen, or a nitrogen-containing gas, such as ammonia, or is heated outside the coating reactor with an infrared radiator, preferably to a temperature between 40°C and 300°C, particularly preferably to a temperature between 60˚C and 200˚C.

11. Method as claimed in claim 10, **characterised in that** during deposition of the coating, the light emission of the plasma, averaged over time, is less than the light emission of the heating plasma, averaged over time, in particular is smaller by at least a factor of 10, preferably by at least a factor of $10^2$, particularly preferably by at least a factor of $10^3$.


**Revendications**

1. Ensemble d'emballage médical comprenant un substrat, **caractérisé en ce que** le substrat comprend un corps creux, en particulier un récipient, de préférence un ensemble d'emballage pharmaceutique, et un revêtement hydrophobe, sans fluor, déposé sur son côté intérieur, qui forme au moins une partie de la surface du substrat revêtu, la couche supérieure contenant comme composant principal un composé avec les éléments Si, C, O et H, d'autres éléments en dehors de Si, C, O, H représentant une teneur inférieure à 10 % atomique, de préférence moins de 5 % atomique, **caractérisé en ce que** le composé présente une composition $SiO_xC_yH_z$, dans laquelle x est inférieur à 1 et le revêtement a un angle de contact pour l'eau $\geq 100˚$.

2. Ensemble d'emballage médical selon la revendication précédente, **caractérisé en ce que** x se situe dans la plage allant de 0,6 à 0,9, de préférence de 0,7 à 0,8 et y se situe dans la plage de 1,2 à 3,3, de préférence dans la plage de 1,5 à 2,5.

3. Ensemble d'emballage médical selon l'une des revendications précédentes, **caractérisé en ce que** le revêtement comprend un polymère, de préférence un polymère réticulé.

4. Ensemble d'emballage médical selon l'une des revendications précédentes, **caractérisé en ce qu'**une couche inorganique présentant la composition $SiO_{1,0\text{-}2,8}C_{0,0\text{-}0,5}$ est insérée entre le revêtement formant la couche supérieure avec un composé présentant les éléments Si, C, O et H et le substrat, et la couche inorganique étant déposée sur la surface du substrat.

5. Ensemble d'emballage médical selon l'une des revendications précédentes, **caractérisé en ce que** le revêtement présente un angle de sortie < 90˚, de préférence < 50˚, de manière hautement préférée < 30˚ pour une goutte d'eau d'un volume de 26 $\mu$l.

6. Récipient rempli ou prêt à être rempli avec un ensemble d'emballage médical selon l'une des revendications précédentes.

7. Procédé pour le revêtement d'ensembles d'emballage médicaux présentant un substrat, **caractérisé en ce que** le substrat comprend un corps creux, en particulier un récipient, de préférence un ensemble d'emballage pharmaceutique, et un revêtement hydrophobe, sans fluor, déposé sur son côté intérieur, qui forme au moins une partie de la surface du substrat revêtu, la couche supérieure contenant comme composant principal un composé avec les éléments Si, C, O et H, **caractérisé en ce que** le composé présente une composition $SiO_xC_yH_z$, dans laquelle x est inférieur à 1, et le revêtement présente un angle de contact pour l'eau $\geq 100˚$, d'autres éléments en dehors de Si, C, O, H représentant une teneur inférieure à 10 % atomique, de préférence moins de 5 % atomique, dans lequel le revêtement est déposé sur le substrat au moyen d'un dépôt en phase vapeur chimique, assisté par plasma, pulsé, un gaz de procédé présentant au moins l'un des composants consistant en hexaméthyldisiloxane, tétra-méthyldisiloxane, hexaméthyldisilazane, TMCTS, TMDSN, TMS ainsi que du carbone et de l'oxygène comme autres composants de gaz étant introduit dans un espace de réaction, qui est limité au moins partiellement par le substrat, et un plasma étant allumé dans l'espace de réaction par injection pulsée d'énergie électromagnétique, des produits de réaction se formant dans le plasma, qui se précipitent sous forme de couche sur le substrat, un plasma pulsé avec des durées d'impulsion de l'ordre de 0,1 $\mu$s à 500 $\mu$s, de préférence de 0,5 $\mu$s à 100 $\mu$s, de manière hautement préférée de 1 $\mu$s à 50 $\mu$s, étant utilisé.

8. Procédé selon la revendication précédente, **caractérisé en ce qu'**un procédé au plasma avec un apport d'énergie moyen par masse $\varepsilon_M$ dans une plage de $10^{-1}$ J/kg jusqu'à $10^9$ J/kg, de préférence dans une plage de $10^2$ J/kg jusqu'à $5 \times 10^6$ J/kg, est utilisé pour la fabrication de la couche supérieure, l'apport d'énergie moyen par masse $\varepsilon_M$ étant défini

par $\quad \varepsilon_M \;=\; \dfrac{\overline{W}}{\sum\limits_{i} F_i \cdot \tilde{M}_i}\quad$, avec le rendement moyen

$$\overline{W} = \frac{\Delta t_{pd}}{\Delta t_{pd} + \Delta t_{pp}} \cdot W_p,$$

formules dans lesquelles $\overline{W}$ désigne le rendement moyen de micro-ondes, $F_i$ le flux de la composante i du mélange de gaz de procédé avec les compo-

sants suivants : $O_2$, précurseur et éventuellement un gaz porteur, $\tilde{M}_i$ la masse moléculaire de la composante i, $\Delta t_{pd}$ la durée d'impulsion, $\Delta t_{pt}$ la pause d'impulsion et $W_p$ la puissance d'impulsion.

9. Procédé selon l'une des revendications précédentes, **caractérisé en ce que**, avec le plasma pulsé, une pause d'impulsion constante est passée entre les impulsions sans injection d'énergie, qui est supérieure à la durée d'impulsion, laquelle se situe de préférence entre 0,1 ms et 200 ms, avec une préférence particulière entre 0,5 ms et 100 ms, avec une préférence toute particulière entre 1 ms et 50 ms, le rapport entre des pauses d'impulsion et des durées d'impulsion étant d'au moins 5:1, de préférence d'au moins 10:1.

10. Procédé selon l'une des revendications précédentes, **caractérisé en ce que** le substrat est réchauffé avant le dépôt de la couche avec un procédé de plasma en utilisant un gaz noble tel que l'argon, ou un gaz inerte, tel que l'azote, ou un gaz à base d'oxygène, tel que de l'oxygène, ou un gaz à base d'azote, tel que l'ammoniac, ou en dehors du réacteur de revêtement avec un émetteur infrarouge, de préférence jusqu'à une température comprise entre 40˚C et 300˚C, avec une préférence particulière jusqu'à une température comprise entre 60˚C et 200˚C.

11. Procédé selon la revendication 10, **caractérisé en ce que** l'émission de lumière du plasma calculée en moyenne lors du dépôt du revêtement dans le temps est plus faible que l'émission de lumière du plasma de réchauffement calculée en moyenne dans le temps, en particulier plus faible d'au moins un facteur 10, de préférence d'au moins un facteur $10^2$, avec une préférence particulière d'au moins un facteur $10^3$.

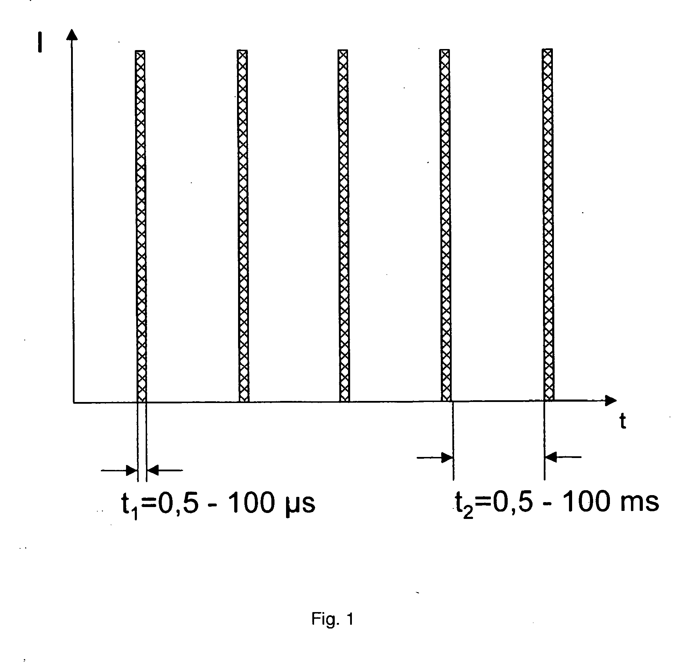

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2504482 A
- DE 19921303 C1
- DE 10258681 A1
- DE 19543133 A1